# EUROPÄISCHE PATENTSCHRIFT

(11) **EP 3 187 032 B1**
(45) Veröffentlichungstag und Bekanntmachung des Hinweises auf die Patenterteilung: **28.03.2018**
(21) Anmeldenummer: 16763883.2
(22) Anmeldetag: 14.09.2016
(51) Int. Cl.: H02M 7/00, H05K 5/02, H05K 7/20, H05K 7/14

(54) **WECHSELRICHTER MIT EINEM MEHRTEILIGEN GEHÄUSE UND INNENLIEGENDEM KÜHLLUFTKANAL**
INVERTER WITH A MULTIPARTITE HOUSING AND AN INTERNAL COOLING-AIR DUCT
ONDULEUR AVEC UN BOÎTIER EN PLUSIEURS PARTIES ET CANAL D'AIR DE REFROIDISSEMENT INTERNE

(30) Priorität: 14.09.2015 DE 102015115421
(43) Veröffentlichungstag der Anmeldung: 05.07.2017
(73) Patentinhaber: SMA Solar Technology AG, 34266 Niestetal (DE)
(72) Erfinder: BETHKE, Lars, 37085 Goettingen (DE); DITTMAR, Jens, 34329 Nieste (DE)
(86) Internationale Anmeldenummer: PCT/EP2016/071726
(87) Internationale Veröffentlichungsnummer: WO 2017/046180

(56) Entgegenhaltungen:
- EP-A1- 2 299 582
- EP-A2- 2 229 044
- DE-A1-102005 031 759
- US-A1- 2013 320 896

## Beschreibung

### TECHNISCHES GEBIET DER ERFINDUNG

Die Erfindung betrifft einen Wechselrichter mit einem mehrteiligen Gehäuse und einem innenliegendem Kühlluftkanal.

### STAND DER TECHNIK

Wechselrichter können elektrische Leistung einer Energieerzeugungseinheit von Gleichstrom in Wechselstrom umwandeln und in ein Energieversorgungsnetz, beispielsweise ein Wechselspannungsnetz, einspeisen und/oder einem elektrischen Verbraucher zu dessen Betrieb direkt zuführen. Als Energieerzeugungseinheit können dabei insbesondere Generatoren verwendet werden, die elektrische Leistung aus regenerativen Quellen erzeugen, beispielsweise Photovoltaik- oder Windgeneratoren.

Ein Gehäuse eines Wechselrichters muss verschiedenen Anforderungen genügen. Dazu gehören insbesondere die Bereitstellung von Anschlüssen für Gleichstrom-, Wechselstrom- und Kommunikationsleitungen, die Aufnahme und Kühlung von leistungselektronischen Komponenten wie Schaltelementen und Wickelgütern sowie die Abschirmung der elektronischen Komponenten gegenüber Umwelteinflüssen. Darüber hinaus soll ein Wechselrichter hinsichtlich seiner äußeren Abmessungen und seines Gewichtes möglichst kompakt aufgebaut sein, wobei eine gute Montierbarkeit seiner Komponenten gewährleistet sein sollte. Die konkrete Ausführung eines Wechselrichters, der die genannten Anforderungen erfüllt, sollte zudem kostenoptimal gestaltet sein.

Herkömmliche Wechselrichter weisen ein gegenüber der Umgebung abgedichtetes Gehäuse mit einem rückseitigen Kühlkörper auf, an den die innerhalb des Gehäuses angeordneten wärmeerzeugenden Komponenten thermisch angebunden sind, so dass der Kühlkörper die Abwärme von den Komponenten aufnehmen und an die Außenluft abgeben kann. Beispielsweise offenbart die EP2299582A1 einen Wechselrichter mit einem Gehäuse, wobei mittig über die Rückseite des Gehäuses ein Kühlluftkanal mit in Längsrichtung des Kühlluftkanals ausgerichteten Kühlrippen verläuft und wobei leistungselektronische Bauteile in dem Gehäuse an der Innenseite einer Außenwand des Gehäuses anliegen, die eine Begrenzungsfläche des Kühlluftkanals bildet.

Aus der EP455969A1 ist ein Sicherheitsnetzteil mit einem geschlossenen Gehäuse mit zwangsbelüfteten Kühleinrichtungen bekannt, die einen Lüftungskanal umfassen, der im Gehäuse verläuft und von diesem dicht getrennt ist, wobei die Kühleinrichtungen mindestens zwei voneinander elektrisch getrennte Kühlkörperabschnitte umfassen, die den Lüftungskanal definieren, in den Lüftungskanal ragende Kühlrippen umfassen und zur getrennten Befestigung von wärmeabgebenden Bauteilen eines Primär- und eines Sekundärkreises ausgebildet sind.

In der US20110261531A1 ist ein Schaltnetzteil mit einem Gehäuse beschrieben, bei dem durch das Gehäuse ein Kühlmittelkanal verläuft, der von einem Kühlmittel durchströmt wird, so dass elektronische Bauteile innerhalb des Gehäuses von dem Kühlmittel gekühlt werden.

DE102013022306A1 offenbart ein Elektrogerät mit einem Gehäuse, einem Kühlkörper und einem Luftleitteil, wobei das Luftleitteil, der Kühlkörper und das Gehäuse einen Kühlluftkanal ausbilden und ein Kühlluftstrom durch den Kühlluftkanal geführt wird.

In der DE102013100607A1 ist ein Wechselrichter mit einem ersten und einem zweiten Gehäusemodul offenbart, bei dem ein in die Umgebung des Wechselrichters mündender Kühlluftkanal in Umfangsrichtung zum Teil von dem ersten Gehäusemodul und zum Teil von dem zweiten Gehäusemodul begrenzt ist.

Aus der DE102005031759A1 ist eine Stromrichteranordnung mit einer Kühleinrichtung und einer Mehrzahl von Halbleitereinrichtungen bekannt, wobei die Kühleinrichtung eine Mehrzahl von Kühlflächen aufweist, die eine äußere Begrenzung der Kühleinrichtung bilden, und wobei die Halbleitereinrichtungen auf mindesten einer der Kühlflächen angeordnet sind. Die Kühleinrichtung kann radialsymmetrisch zu ihrer Längsachse aufgebaut sein, zur Durchströmung mit Luft entlang der Längsachse ausgebildet und insbesondere sechs Kühlflächen aufweisen.

Die US20130320896A1 und die EP2229044A2 offenbaren Anordnungen für einen modularen Wechselrichter bzw. für ein Motorsteuergerät mit einer Mehrzahl von Leistungshalbleitern und Kühlelementen, die mit den Leistungselementen verbunden und derart um eine zentrale Achse angeordnet sind, dass ein Kanal gebildet wird, der von einem Kühlmedium durchflossen werden kann.

### AUFGABE DER ERFINDUNG

Der Erfindung liegt die Aufgabe zugrunde, einen Wechselrichter mit einem mehrteiligen Gehäuse aufzuzeigen, wobei das Gehäuse eine hinreichende Abfuhr der Verlustwärme der leistungselektronischen Komponenten gewährleistet und zugleich kompakte Außenmaße und ein geringes Gewicht auch für hohe elektrische Leistung bis in Bereiche einiger zehn Kilowatt aufweist sowie kostengünstig herstellbar ist.

### LÖSUNG

Die Aufgabe wird durch einen Wechselrichter mit den Merkmalen des Patentanspruchs 1 gelöst. Bevorzugte Ausführungsformen sind in den abhängigen Patentansprüchen definiert.

### BESCHREIBUNG DER ERFINDUNG

Ein Wechselrichter zur Umwandlung eines eingangsseitigen Gleichstroms in einen ausgangsseitigen Wechselstrom zur Einspeisung in ein Wechselspannungsnetz umfasst einen ersten Gehäuseteil mit Gleichstromanschlüssen zur Aufnahme von Gleich-stromleitungen eines Gleichstromgenerators, einen zweiten Gehäuseteil mit Wechselstromanschlüssen zur Aufnahme von Wechselstromleitungen eines Wechselspannungsnetzes, einen dritten Gehäuseteil zur Aufnahme von leistungselektronischen Komponenten eines Gleichspannungswandlers, und einen vierten Gehäuseteil zur Aufnahme von leistungselektronischen Komponenten einer Wechselrichterbrückenschaltung. Die Gehäuseteile weisen jeweils eine im Wesentlichen ebene Rückwand auf und sind derart angeordnet, dass sie einen Kühlluftkanal mit im Wesentlichen rechteckigem Querschnitt umschließen, wobei der erste Gehäuseteil gegenüber dem zweiten Gehäuseteil und der dritte Gehäuseteil gegenüber dem vierten Gehäuseteil angeordnet sind. Der Wechselrichter ist dadurch gekennzeichnet, dass in dem Kühlluftkanal ein Kühlkörper angeordnet ist, der zwei gegenüberliegende und im Wesentlichen ebene Kühlflächen aufweist, wobei die Kühlflächen den Rückwänden des dritten Gehäuseteils und des vierten Gehäuseteils zugeordnet sind und mit in diesen Gehäuseteilen angeordneten leistungselektronischen Komponenten in thermischem Kontakt stehen.

Ein Wechselrichter mit einem solchen Aufbau weist kompakte äußere Abmessungen auf, da die für die Umwandlung des eingangsseitigen Gleichstroms in den ausgangsseitigen Wechselstrom notwendigen elektrischen, elektronischen und elektromechanischen Komponenten auf mehrere Gehäuseteile verteilt angeordnet sind. Dadurch, dass der Kühlkörper zwei Kühlflächen aufweist und zwischen dem dritten und dem vierten Gehäuseteil angeordnet ist, können insbesondere die leistungselektronischen Komponenten des Wechselrichters, die erfahrungsgemäß am meisten Verlustwärme erzeugen, innerhalb des dritten und des vierten Gehäuseteils auf einer im Vergleich zu herkömmlichen Wechselrichtern vergrößerten Kühlfläche platziert werden, wobei gleichzeitig die Dimensionen des Wechselrichters, d.h. seine Höhe, Breite und Tiefe, optimal aufeinander angepasst werden können. Insbesondere die Aufteilung der Komponenten des Wechselrichters in Komponenten des Gleichspannungswandlers und Komponenten der Wechselrichter-Brückenschaltung und deren Verteilung auf verschiedene Gehäuseteile auf gegenüberliegenden Seiten des Kühlluftkanals ermöglicht es, eine Wechselrichter mit großer Nennleistung zu konstruieren, der zwar in einer normal zu den Kühlflächen ausgerichteten Dimension, beispielsweise einer Bautiefe, größer, dafür jedoch in den Dimensionen parallel zu den Kühlflächen, also beispielsweise seiner Breite und Höhe, erheblich kleiner als ein herkömmlich aufgebauter Wechselrichter mit vergleichbarer Nennleistung ist. Zudem stehen im ersten und im zweiten Gehäuseteil Bauräume zur Verfügung, die optimal für die Aufnahme von Komponenten geeignet sind, die wenig oder einer vernachlässigbare Verlustwärme erzeugen und daher keine oder zumindest keine besonderen Anforderungen an ihre Kühlung stellen. Der erfindungsgemäße Wechselrichter bietet den weiteren Vorteil, dass Anschlussbereiche für Gleichstrom- und Wechselstromleitung an gut zugänglichen Stellen positioniert werden können, so dass eine Inbetriebnahme des Wechselrichters einfach und sicher durchgeführt werden kann.

Ein zweistufiger Wechselrichter mit einem Gleichspannungswandler und einer Wechselrichter-Brückenschaltung weist in der Regel einen Gleichspannungszwischenkreis auf, der insbesondere bei großen Nennleistungen im Bereich einiger zehn bis einige hundert Kilowatt aus einer großen Anzahl an Kondensatoren bestehen kann. Bei einem erfindungsgemäßen Wechselrichter ist der Gleichspannungszwischenkreis bevorzugt auf den dritten und den vierten Gehäuseteil aufgeteilt, d.h. ein erster Teil des Gleichspannungszwischenkreises ist in dem dritten Gehäuseteil und ein zweiter Teil des Gleichspannungszwischenkreises ist in dem vierten Gehäuseteil angeordnet. Bevorzugt weisen der erste und der zweite Teil des Gleichspannungszwischenkreises in etwa gleiche Kapazitäten auf, so dass der Gleichspannungszwischenkreis etwa hälftig auf den dritten und den vierten Gehäuseteil aufgeteilt ist. Zumindest befindet sich etwa ein Viertel der Kapazität des Gleichspannungszwischenkreises in einem Gehäuseteil und drei Viertel der Kapazität in dem anderen Gehäuseteil. Durch diese Aufteilung kann der zur Verfügung stehende Bauraum optimal ausgenutzt werden. Zudem ergeben sich durch diese Aufteilung Vorteile in der elektromagnetischen Verträglichkeit (EMV) des Wechselrichters. Insbesondere können Kabelstrecken vom Gleichspannungswandler zum Gleichspannungszwischenkreis und weiter vom Gleichspannungszwischenkreis zur Wechselrichterbrückenschaltung sehr kurz gehalten werden; gerade auf diesen Kabelstrecken bewirkt eine Taktung von Schaltelementen des Gleichspannungswandlers bzw. der Wechselrichterbrückenschaltung eine hochfrequente Modulation und damit eine potentielle Abstrahlung, während eine Spannung des Gleichspannungszwischenkreises und damit auch Verbindungsleitungen zwischen den in verschiedenen Gehäuseteilen angeordneten Teilen des Gleichspannungszwischenkreises weitgehend frei von hochfrequenten Modulationen sind.

In einer weiteren Ausführungsform des Wechselrichters sind der erste Teil und der zweite Teil des Gleichspannungszwischenkreises über Zwischenkreisverbindungsleitungen elektrisch miteinander verbunden, die innerhalb eines röhrenförmigen Verbindungskanals zwischen dem dritten Gehäuseteil und dem vierten Gehäuseteil verlaufen. Dabei ist eine Außenwand des Verbindungskanal elektrisch isolierend ausgeführt ist. Der Verbindungskanal weist bevorzugt mindestens zwei Teilkanäle zur Aufnahme von Zwischenkreisverbindungsleitungen mit einem positiven und einem negativen Potential auf, wobei die Teilkanäle axial entlang des Verbindungskanals verlaufen und mittels einer axial verlaufenden Trennwand elektrisch gegeneinander isoliert sind. Darüber hinaus kann der Verbindungskanal einen dritten Teilkanal zur Aufnahme von Zwischenkreisverbindungsleitungen mit einem Mittelpunktspotential des Gleichspannungszwischenkreises aufweisen, wobei der dritte Teilkanal ebenfalls axial entlang des Verbindungskanals verläuft und gegenüber dem ersten und dem zweiten Teilkanal mittels einer weiteren axial verlaufenden Trennwand elektrisch isoliert.

Dadurch, dass die innerhalb des Verbindungskanals verlaufenden Zwischenkreisverbindungsleitungen einerseits durch die elektrisch isolierende Außenwand gegenüber den Gehäuseteilen und ggf. der Umgebung und andererseits durch die elektrisch isolierenden Trennwände gegeneinander elektrisch isoliert sind, kann auf eine Isolierung der Zwischenkreisverbindungsleitungen selbst verzichtet werden oder diese auf ein Minimum reduziert werden, wobei die Einhaltung ggf. normativ geforderter Isolationsabstände durch die Trennwände gewährleistet wird. Insbesondere können die Zwischenkreisverbindungsleitungen hochflexibel ausgeführt werden und insbesondere jeweils ein Geflecht elektrisch leitender Drähte umfassen, so dass es möglich ist, die Zwischenkreisverbindungsleitungen innerhalb des dritten und des vierten Gehäuseteiles mit sehr engen Radien zu verlegen, um eine Anbindung an die Teile des Gleichspannungszwischenkreises herzustellen. Konkret können die Zwischenkreisverbindungsleitungen beispielsweise nach ihrem Austritt aus dem Verbindungskanal auf engstem Raum um 90 Grad oder 180 Grad abbiegen und auf einer Leiterplatte angebracht werden, die die Kondensatoren des Gleichspannungszwischenkreises aufnimmt. Dadurch wird sowohl die Montage des Wechselrichters vereinfacht als auch der verfügbare Bauraum optimal genutzt.

Der Verbindungskanal kann zwei Teilröhren umfassen, wobei sich jeweils eine Teilröhre in den dritten Gehäuseteil und in den vierten Gehäuseteil erstreckt. Die Teilröhren können separat in den Gehäuseteilen montiert werden, so dass sich durch den Zusammenbau des Wechselrichters ein durchgängiger Verbindungskanal ergibt; alternativ können die Teilröhren auch nach dem Zusammenbau der Gehäuseteile vom Inneren der Gehäuseteil durch deren Rückwände durchgesteckt werden. Dadurch wird die Montage des Wechselrichters weiter vereinfacht.

In einer Ausführungsform des Wechselrichters sind in dem ersten Gehäuseteil und/oder in dem zweiten Gehäuseteil Wickelgüter angeordnet, die als Filterdrosseln und/oder als Speicherdrosseln ausgeführt und zur Filterung bzw. Speicherung des umzuwandelnden Gleichstroms und/oder des umgewandelten Wechselstromes eingerichtet sind. Diese Wickelgüter sind in der Regel notwendig für den Betrieb des Wechselrichters, nehmen einen signifikanten Bauraum in Anspruch und tragen einen wesentlichen Anteil am Gesamtgewicht des Wechselrichters. Durch Ihre Anordnung im ersten und zweiten Gehäuseteil kann eine ausgewogene Gewichtsverteilung erzielt werden und die Montage des Wechselrichters wird weiter vereinfacht, indem die Wickelgüter unabhängig von der Montage der im dritten und vierten Gehäuseteil angeordneten Komponenten des Gleichspannungswandlers und der Wechselrichter-Brückenschaltung erfolgen kann. Da im ersten und im zweiten Gehäuseteil auch die Gleichstrom- bzw. Wechselstromanschlüsse angeordnet sind, kann eine für die EMV vorteilhaft kurze Länge von Leitungen zwischen den Eingangs- bzw. Ausgangsanschlüssen und den elektrisch in der Regel eingangsseitig des Gleichspannungswandlers und ausgangsseitig der Wechselrichter-Brückenschaltung angeordneten Wickelgütern erzielt werden. Darüber hinaus erweist es sich als vorteilhaft, einen Gleichstrom-Trennschalter im ersten Gehäuseteil und/oder ein Wechselstrom-Trennschalter im zweiten Gehäuseteil angeordnet ist.

In einer Ausführungsform des Wechselrichters umfasst der Kühlkörper ein von den Gehäuseteilen separates, einteiliges oder mehrteiliges Bauteil. Dieses Bauteil kann insbesondere ein Strangpressprofil umfassen, das einfach und kostengünstig herstellbar ist. Dabei können gegenüberliegende Kühlflächen des Kühlkörpers in korrespondierenden Aussparungen in den Rückwänden des dritten Gehäuseteiles und des vierten Gehäuseteiles eingepasst sind. Dadurch können innerhalb des dritten und vierten Gehäuseteiles angeordnete zu kühlende Komponenten direkt auf den Kühlflächen montiert werden, ohne dass etwaige durchgängige Rückwände des dritten oder vierten Gehäuseteils der Wärmeabfuhr einen zusätzlichen thermischen Widerstand entgegenstellen.

Alternativ kann der Kühlkörper durch Kühlrippen gebildet sein, die an den einander gegenüberliegenden Rückwänden des dritten Gehäuseteiles und des vierten Gehäuseteiles angeordnet sind. Dies ermöglicht ebenfalls einen optimalen thermischen Kontakt zwischen den zu kühlenden Komponenten, vereinfacht die Montage und gewährleistet eine optimale Abdichtung der Innenräume des dritten und des vierten Gehäuseteils gegenüber dem Kühlluftkanal und damit gegenüber der Umgebung.

Der Wechselrichter kann mindestens einen weiteren Kühlkörper aufweisen, der an der Rückwand des ersten Gehäuseteils oder des zweiten Gehäuseteils angeordnet und zur Kühlung der in dem ersten Gehäuseteil und/oder der in dem zweiten Gehäuseteil angeordneten Wickelgüter eingerichtet ist sowie mit dem Kühlluftkanal in thermischer Verbindung steht, so dass der weitere Kühlkörper Wärme von den Wickelgütern aufnimmt und an den Kühlluftkanal durchströmende Kühlluft abgibt. Dadurch steht eine weitere Kühlfläche innerhalb des ersten und/oder des zweiten Gehäuseteils zur Verfügung, die eine Kühlung der Wickelgüter ohne zusätzlichen Montageaufwand und mit keiner oder nur geringfügiger Vergrößerung der Abmessungen des Wechselrichters gewährleistet.

In einer Ausführungsform des Wechselrichter kann an einem Ende des Kühlluftkanals eine Lüftereinheit angeordnet ist, die dazu eingerichtet ist, einen Kühlluftstrom durch den Kühlkanal zu erzeugen. Dadurch kann die Kühlleistung des Kühlkörpers erheblich vergrößert werden bzw. der Kühlkörper zur Erzielung der erforderlichen Kühlleistung erheblich kleiner ausgeführt werden als ohne eine Lüftereinheit. Die Lüftereinheit kann in einer Richtung senkrecht zur Achse des Kühlluftkanals verschiebbar sein, wobei die Verschiebung durch einen Verriegelungsvorrichtung lösbar blockiert wird, so dass die Lüftereinheit aus dem Wechselrichter entnommen werden kann. Dadurch wird Reinigung, Wartung und ggf. Reparatur bzw. Austausch eines Lüfters der Lüftereinheit erheblich vereinfacht.

Auf der der Lüftereinheit gegenüberliegenden Seite des Kühlluftkanals kann eine Abdeckung angeordnet sein. Diese Abdeckung schützt den Kühlluftkanal vor Verschmutzungen aus der Umgebung des Wechselrichters und kann den aus dem Kühlluftkanal austretenden Kühlluftstrom umlenken und dadurch verhindern, dass etwaige mit dem Kühlluftstrom aus dem Kühlluftkanal austretende Verschmutzungen, insbesondere Partikel, in den Kühlluftkanal zurückfallen. Darüber hinaus kann die Abdeckung von außen auftreffendes Wasser, insbesondere Regenwasser ableiten und an eine geeignete Stelle führen, an der es gut ablaufen kann.

In einer Ausführungsform des Wechselrichters kann an einer Montageseite des Wechselrichters ein Positioniervorrichtung vorgesehen sein, wobei die Montageseite des Wechselrichters normal zur Achse des Kühlluftkanals ausgerichtet ist. Die Positioniervorrichtung kann zur Aufstellung des Wechselrichters auf einer im Wesentlichen horizontale Fläche eingerichtet ist, so dass der Kühlluftkanal nach einer Montage des Wechselrichters lotrecht ausgerichtet ist. Damit kann der Wechselrichter als Standgerät betrieben werden, wodurch die Aufstellung und Inbetriebnahme erheblich vereinfacht ist, insbesondere wenn der Wechselrichter eine hohe Nennleistung im Bereich einiger Dutzend Kilowatt und eine dementsprechend hohes Eigengewicht aufweist. Alternativ kann die Positioniervorrichtung zur Aufhängung des Wechselrichters an einer Wand eingerichtet ist, so dass nach einer Montage die Montageseite des Wechselrichters parallel zur Wand und der Kühlluftkanal des Wechselrichters senkrecht zur Wand ausgerichtet ist.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt einen erfindungsgemäßen Wechselrichter mit einem Gehäuse in einem montierten Zustand,
- Fig. 2: zeigt einen erfindungsgemäßen Wechselrichter mit einem Gehäuse in einer Explosionsdarstellung,
- Fig. 3: zeigt eine weitere Explosionsdarstellung eines erfindungsgemäßen Wechselrichters,
- Fig. 4a: zeigt eine Detailansicht eines Verbindungskanals zwischen Gehäuseteilen eines erfindungsgemäßen Wechselrichters in einer Explosionsdarstellung,
- Fig. 4b: zeigt eine Detailansicht des Verbindungskanals in einer Explosionsdarstellung,
- Fig. 5: zeigt einen erfindungsgemäßen Wechselrichters in einem an einer Wand montierten Zustand, und
- Fig. 6: zeigt eine Lüftereinheit eines erfindungsgemäßen Wechselrichters.

### FIGURENBESCHREIBUNG

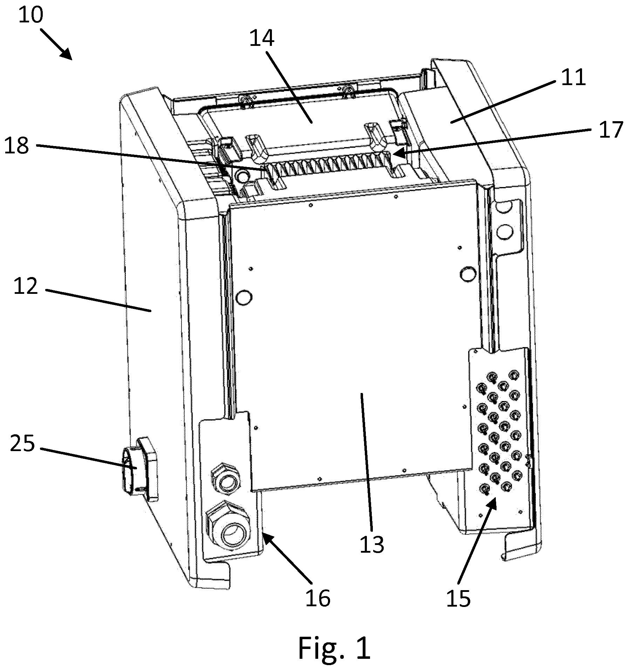

**Fig. 1** zeigt einen Wechselrichter 10 mit einem Gehäuse, das einen ersten Gehäuseteil 11, einen zweiten Gehäuseteil 12, einen dritten Gehäuseteil 13 und einen vierten Gehäuseteil 14 umfasst. Die Gehäuseteile 11 bis 14 sind jeweils angrenzend zueinander angeordnet und bilden dadurch eine im Wesentlichen rechteckige Anordnung.

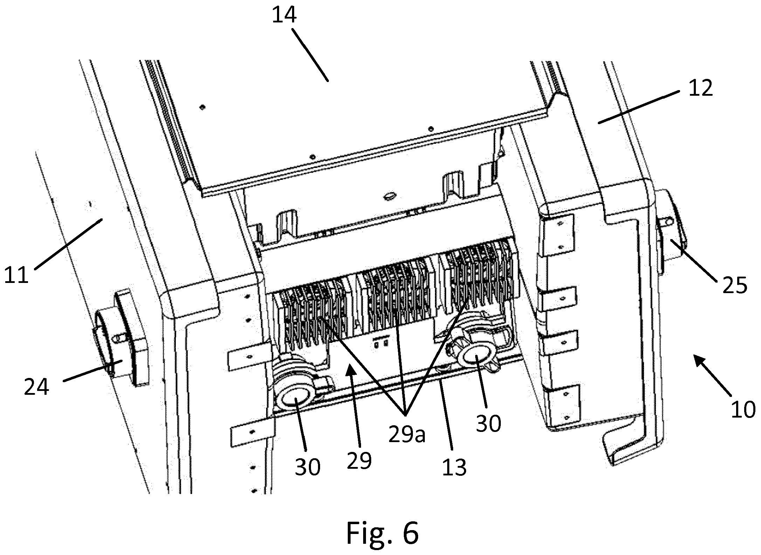

Der erste Gehäuseteil 11 weist Gleichstrom-Anschlüsse 15 auf, an die Gleichstromleitungen eines Generators, beispielsweise eines Photovoltaik-Generators angeschlossen werden können. Die Gleichstrom-Anschlüsse 15 umfassen jeweils paarweise für positive und negative Polarität vorgesehene Anschlussstecker, wobei an jedes Paar ein Generator angeschlossen werden kann. Innerhalb des ersten Gehäuseteils 11 können weitere, hier der Übersichtlichkeit halber nicht dargestellte elektrische, elektronische oder elektromechanische Komponenten angeordnet sein, insbesondere ein Gleichstrom-Trennschalter 24 (siehe Fig. 6), Sicherungen und Überspannungsschutzvorrichtungen sowie Wickelgüter zur Speicherung und/oder Filterung des vom Wechselrichter 10 umzuwandelnden Gleichstroms.

Der zweite Gehäuseteil 12 ist gegenüberliegend zum ersten Gehäuseteil 11 angeordnet und im Wesentlichen parallel dazu ausgerichtet. Der zweite Gehäuseteil 12 weist WechselstromAnschlüsse 16 auf, an die Wechselstromleitungen angeschlossen werden können, die insbesondere Teil eines Wechselspannungsnetzes sein können, so dass der Wechselrichter 10 einen Wechselstrom, der aus dem über die Gleichstrom-Anschlüsse 15 empfangenen Gleichstrom erzeugt wird, in ein Wechselspannungsnetz einspeisen kann. Innerhalb des zweiten Gehäuseteils 12 können weitere elektrische, elektronische oder elektromechanische Komponenten angeordnet sein, insbesondere ein Wechselstrom-Trennschalter 25 sowie hier der Übersichtlichkeit halber nicht dargestellte Sicherungen und Überspannungsschutzvorrichtungen sowie Wickelgüter zur Speicherung und/oder Filterung des vom Wechselrichter 10 erzeugten Wechselstroms.

Der dritte Gehäuseteil 13 grenzt mit seinen Seitenflächen an die Rückseiten des ersten Gehäuseteils 11 und des zweiten Gehäuseteils 12 und ist insofern zwischen den Gehäuseteilen 11, 12 angeordnet. Innerhalb des dritten Gehäuseteils 13 ist mindestens ein Gleichspannungswandler angeordnet, dessen Komponenten, die insbesondere leistungselektronische Halbleiterschalter, Speicherkondensatoren und Ansteuerelektronik umfassen können, hier der Übersichtlichkeit halber nicht dargestellt sind. Je nach Anzahl der anschließbaren Generatoren können auch mehrere, insbesondere parallel geschaltete Gleichspannungswandler im dritten Gehäuseteil 12 angeordnet sein.

Der vierte Gehäuseteil 14 ist gegenüberliegend zum dritten Gehäuseteil 13 angeordnet, im Wesentlichen parallel dazu ausgerichtet und grenzt mit seinen Seitenflächen an die Rückseiten des ersten Gehäuseteils 11 und des zweiten Gehäuseteils 12 und ist insofern zwischen den Gehäuseteilen 11, 12 angeordnet. Innerhalb des vierten Gehäuseteils 14 ist mindestens eine Wechselrichter-Brückenschaltung angeordnet, deren Komponenten, die insbesondere leistungselektronische Halbleiterschalter, Speicherkondensatoren und Ansteuerelektronik umfassen können, hier der Übersichtlichkeit halber nicht dargestellt sind. Je nach gewählter Topologie der Wechselrichter-Brückenschaltung sowie abhängig von der umzuwandelnden Gesamtleistung können auch mehrere, insbesondere parallel geschaltete Wechselrichterbrücken im vierten Gehäuseteil 14 angeordnet sein.

In einer alternativen Ausführungsform können die Gehäuseteile 11 bis 14 auch derart angeordnet sein, dass die Seitenflächen des ersten Gehäuseteiles 11 und des zweiten Gehäuseteiles 12 an die Rückseiten des dritten Gehäuseteiles 13 und/oder des vierten Gehäuseteiles 14 angrenzen, so dass der erste Gehäuseteil 11 und/oder der zweite Gehäuseteils 12 zwischen dem dritten Gehäuseteil 13 und dem vierten Gehäuseteil 14 angeordnet sind.

Die Gehäuseteile 11 bis 14 sind derart angeordnet, dass durch ihre Rückwände ein Kühlluftkanal 17 mit einem im Wesentlichen rechteckigen Querschnitt gebildet wird. Innerhalb dieses Kühlluftkanals 17 ist ein Kühlkörper 18 angeordnet. Zumindest einige der in dem dritten Gehäuseteile 13 und dem vierten Gehäuseteil 14 angeordneten leistungselektronischen Komponenten, insbesondere solche, die im Betrieb eine signifikante Verlustwärme erzeugen und daher eine erweiterte Kühlung benötigen, sind derart in diesen Gehäuseteilen 13 und 14 angeordnet, dass sie in thermischem Kontakt zu dem Kühlkörper 18 stehen, so dass die von diesen leistungselektronischen Komponenten erzeugte Verlustwärme über den Kühlkörper 18 an die Umgebung abgegeben werden kann.

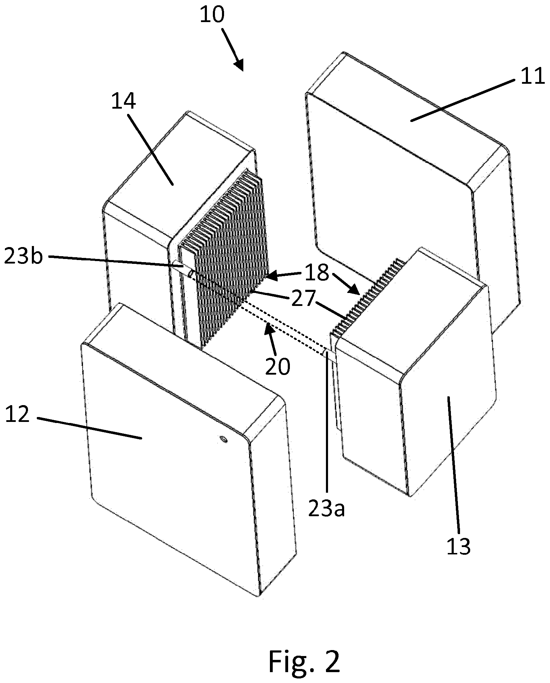

**Fig. 2** zeigt eine Ausführungsform eines erfindungsgemäßen Wechselrichters 10 in einer Explosionsdarstellung. Die Gehäuseteile 11 bis 14 sind hier vereinfacht und beabstandet zueinander dargestellt, wie sie beispielsweise vor einem Zusammenbau des Wechselrichters 10 vorliegen können. Der Kühlkörper 18 wird durch Kühlrippen 27 gebildet, die an den Rückseiten des dritten Gehäuseteiles 13 und des vierten Gehäuseteiles 14 angeordnet sind. Nach einem Zusammenbau des Wechselrichters 10 können die sich gegenüberstehenden Kühlrippen beabstandet zueinander sein, aneinanderstoßen oder sich überlappen.

Zum Betrieb des einen Gleichspannungswandler und eine Wechselrichterbrücke aufweisenden Wechselrichters 10 ist regelmäßig ein Gleichspannungszwischenkreis notwendig, der je nach Nennleistung des Wechselrichters 10 eine Anzahl an Kondensatoren umfassen kann. Die Kondensatoren des Gleichspannungszwischenkreises können entweder in dem dritten Gehäuseteil 13 oder in dem vierten Gehäuseteil 14 angeordnet oder auf die Gehäuseteile 13 und 14 aufgeteilt sein.

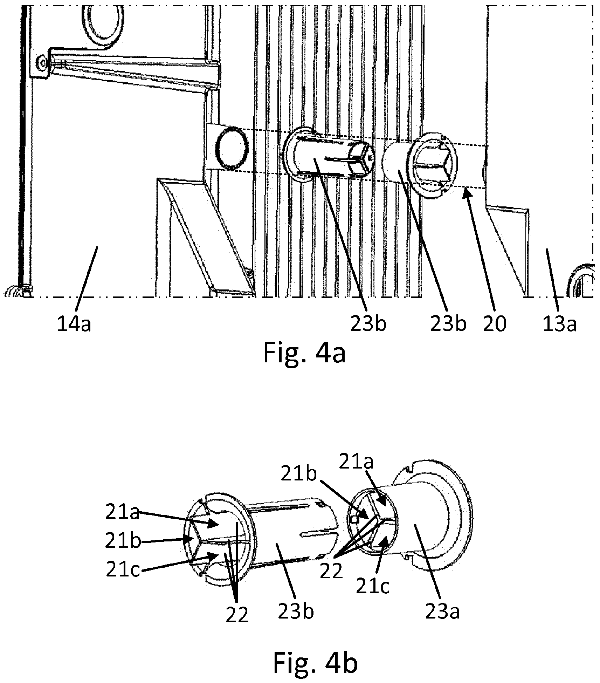

Der Wechselrichter 10 weist einen Verbindungskanal 20 auf, der hier beispielhaft aus zwei Teilröhren 23a, 23b besteht, wobei der Verbindungkanal 20 selbst in der Fig. 2 durch eine gestrichelte Verbindung der Teilröhren 23a, 23b angedeutet ist und diese Teilröhren 21a, 21b nach dem Zusammenbau des Wechselrichters 10 aneinanderstoßen, überlappen oder ineinander gesteckt sind. Dieser Verbindungskanal 20 ist dafür vorgesehen, Zwischenkreisverbindungsleitungen aufzunehmen, die einen im dritten Gehäuseteil 13 angeordneten ersten Teil eines Gleichspannungszwischenkreises mit einem im vierten Gehäuseteil 14 angeordneten zweiten Teil des Gleichspannungszwischenkreises verbinden. Details eines beispielhaften Aufbaus des Verbindungskanals 20 werden im Zusammenhang mit den Figuren 4a und 4b offenbart.

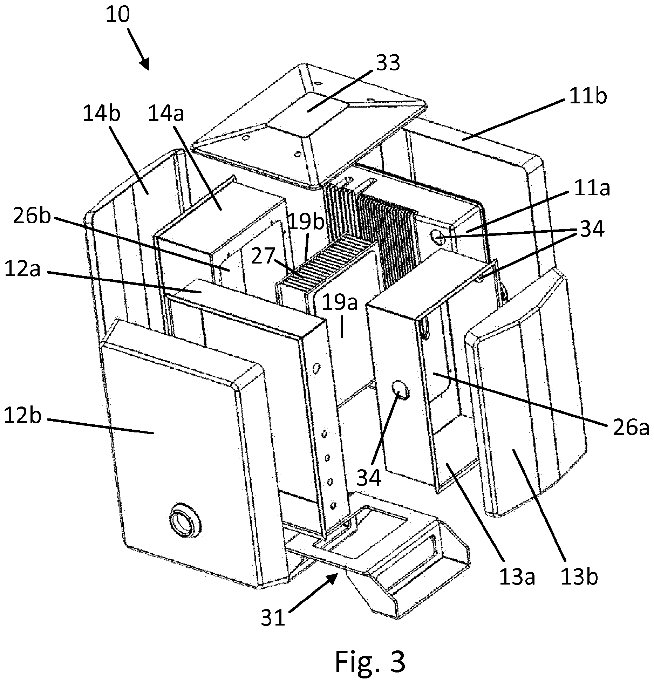

**Fig. 3** zeigt eine weitere Ausführungsform eines erfindungsgemäßen Wechselrichters 10 in einer Explosionsdarstellung. Die Gehäuseteile 11 bis 14 umfassen hier jeweils Grundkörper 11a, 12a, 13a, 14a und zugehörige Deckel 11b, 12b, 13b, 14b. Der Kühlkörper 18 ist in dieser Ausführungsform als separates, einstückiges Bauteil ausgeführt und kann beispielsweise in Form eines Strangpressprofils hergestellt werden. Alternativ kann der Kühlkörper 18 auch aus mehreren Teilen bestehen, insbesondere aus zwei sich gegenüberstehenden Strangpressprofilen. Auch andere Herstellverfahren wie beispielsweise Druckguss sind denkbar. Der Kühlkörper 18 weist zwei Kühlflächen 19a, 19b auf, die jeweils mit den Kühlrippen 27 verbunden sind. Die Grundkörper 13a, 14a des dritten Gehäuseteils 13 und des vierten Gehäuseteils 14 weisen Aussparungen 26a, 26b auf, deren Kontur derart ausgebildet ist, dass die Kühlfläche 19a die Rückwand des Grundkörpers 13a und die Kühlfläche 19b die Rückwand des Grundkörpers 14a dicht abschließt. Der in Fig. 3 nicht bezeichnete Kühlluftkanal 17 wird somit durch die Kühlflächen 19a, 19b und die Rückwände der Grundkörper 11a, 12a gebildet. Zusätzlich weist der Grundkörper 11a des ersten Gehäuseteils 11 optional einen weiteren Kühlkörper 28 auf, der hier beispielhaft als in die Rückwand des Grundkörpers 11a integrierte Kühlrippen ausgeführt ist. Alternativ kann der Kühlkörper 28 als separates Bauteil ausgeführt sein, der an der Rückwand des Grundkörpers 11a angebracht oder in eine Aussparung in dieser Rückwand eingepasst werden kann.

Der Wechselrichter 10 gemäß Fig. 3 weist eine Positioniervorrichtung 31 auf, die an einer Montageseite des Wechselrichters 10 angeordnet ist, wobei die Montageseite des Wechselrichters 10 sich an einem Ende des Kühlluftkanals 17 befindet und normal zur Achse des Kühlluftkanals 17 ausgerichtet ist. Die Positioniervorrichtung 31 gemäß Fig. 3 ist als Standfuß ausgebildet, so dass der Wechselrichter 10 auf eine im Wesentlichen ebene Fläche gestellt werden kann, so dass ein Kühlluftstrom den Kühlkörper 18 in lotrechter Richtung durchströmt und an dem weiteren Kühlkörper 28 vorbeiströmt. Wenn eine Zwangslüftung vorgesehen ist, die insbesondere eine Lüftereinheit 29 gemäß Fig. 6 umfassen kann, kann die Strömungsrichtung wahlweise von unten nach oben oder von oben nach unten eingestellt werden.

Als oberer Abschluss des Kühlluftkanals 17 ist eine Abdeckung 33 vorgesehen, die den Kühlluftkanal 17 überdeckt und vor Verschmutzung schützt. Der aus dem Kühlluftkanal 17 austretende Kühlluftstrom kann durch die Abdeckung umgelenkt werden, so dass insbesondere verhindert wird, dass etwaige mit dem Kühlluftstrom aus dem Kühlluftkanal 17 austretende Verschmutzungen, z.B. Partikel, in den Kühlluftkanal 17 zurückfallen. Darüber hinaus kann die Abdeckung 33 von außen auftreffendes Wasser, insbesondere Regenwasser ableiten und an eine geeignete Stelle führen, an der es problemlos ablaufen kann.

Die Grundkörper 11a, 12a, 13a, 14a können an ihren Rückwänden und/oder Seitenwänden Öffnungen 34 aufweisen, durch die Kabelverbindungen zur Verbindung der in den Gehäuseteilen 11 bis 14 angeordneten elektrischen, elektronischen oder elektromechanischen Komponenten zwischen den Gehäuseteilen 11 bis 14 geführt werden können. Dazu sind die Öffnungen 34 derart angeordnet, dass eine Öffnung 34 in einem der Grundkörper 11a, 12a, 13a, 14a jeweils mit einer Öffnung 34 in einem der jeweils angrenzenden Grundkörper 11a, 12a, 13a, 14a räumlich zusammenfällt, so dass die dadurch entstehende Durchführungsöffnung mittels geeigneter Dichtungen abgedichtet werden kann.

**Fig. 4a** zeigt eine Detailansicht einer Ausführungsform des Verbindungskanals 20, der bereits in Zusammenhang mit Fig. 2 erläutert wurde und in Fig. 3 der Übersichtlichkeit halber nicht dargestellt ist. Der Verbindungskanal 20 verläuft zwischen den Rückwänden der Grundkörper 13a und 14a des dritten Gehäuseteils 13 und des vierten Gehäuseteils 14 und besteht in dieser Ausführungsform aus zwei Teilröhren 21a, 21b, die nach dem Zusammenbau des Wechselrichters 10 ineinander gesteckt sind. Alternativ können die Teilröhren 21a, 21b nach dem Zusammenbau des Wechselrichters 10 aneinanderstoßen und es kann eine zusätzliche Dichtung an der Stoßstelle der Teilröhren 21a, 21b vorgesehen sein. Nach dem Zusammenbau des Wechselrichters 10 erstreckt sich die Teilröhre 21a in den dritten Gehäuseteil 13 und die Teilröhre 21b in den vierten Gehäuseteil 14, so dass insbesondere Zwischenkreisverbindungsleitungen in dem durch die Teilröhren 21a, 21b gebildeten Verbindungskanal 20 verlaufen können, um die in den Gehäuseteilen 13 und 14 angeordneten Teile des Gleichspannungszwischenkreises des Wechselrichters 10 miteinander zu verbinden.

**Fig. 4b** zeigt eine weitere Detailansicht der Teilröhren 23a, 23b. Die Teilröhren 23a, 23b weisen Teilkanäle 21a, 21b, 21c auf, die durch Trennwände 22 voneinander getrennt sind. Die Außenwände der Teilröhren sowie die Trennwände 22 können elektrisch isolierende Eigenschaften aufweisen, so dass Zwischenkreisverbindungsleitungen, die innerhalb der Teilkanäle 21a, 21b, 21c verlaufen, sowohl gegeneinander als auch jeweils gegenüber den Grundkörpern 13a, 14a des dritten Gehäuseteils 13 und des vierten Gehäuseteils 14 (vergleiche Figur 4a) elektrisch isoliert sind. Dadurch kann auf eine separate Isolierung der Zwischenkreisverbindungsleitungen verzichtet werden und es können im wesentlichen unisolierte Leiter verwendet werden, die für sich genommen keine hinreichende Isolation gegeneinander und gegenüber elektrisch leitfähigen Gehäuseteilen aufweisen. Insbesondere können Geflechtbänder als Zwischenkreisverbindungsleitungen verwendet werden. Derartige Geflechtbänder, die aus einem Geflecht einzelner Drähte oder Litzen bestehen, weisen eine hohe Flexibilität auf und können mit engen Radien verlegt werden, ohne dass die einzelnen Litzen auffächern.

Zur Verbindung der in den Gehäuseteilen 13a und 14a angeordneten Teile des Gleichspannungszwischenkreises miteinander werden mindestens zwei Zwischenkreisverbindungsleitungen benötigt, d.h. jeweils eine für den positiven und eine für den negativen Pol des durch die Verbindung gebildeten Gesamtzwischenkreises. Diese mindestens zwei Zwischenkreisverbindungsleitungen können in den Teilkanälen 21a und 21b angeordnet sein. Der Teilkanal 21c, sofern vorhanden, kann eine weitere Zwischenkreisverbindungsleitung aufnehmen, die etwaige Mittelpunktspotentiale der Teile des Gleichspannungszwischenkreises verbindet. Darüber hinaus können weitere Leitungen, beispielsweise zur Bordnetzversorgung oder auch zur Übertragung von Steuer- oder Kommunikationssignalen, in Teilkanal 21c oder in weiteren Teilkanälen angeordnet sein.

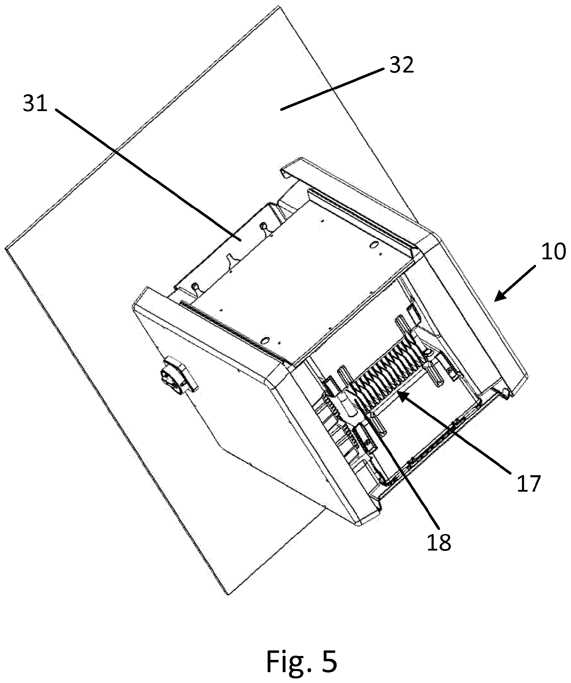

Fig. 5 zeigt einen erfindungsgemäßen Wechselrichter 10 in einer Montageposition an einer Wand 32. Der Wechselrichter 10 weist eine Positioniervorrichtung 31 auf, die in dieser Ausführungsform als Wandhalterung ausgebildet ist. Dazu kann die Positioniervorrichtung 31 einerseits an der bereits in Zusammenhang mit Fig. 3 definierten Montageseite befestigt werden, beispielsweise mittels Schrauben, und andererseits an der Wand 32 befestigt werden, beispielsweise mittels Schrauben angeschraubt oder an Haken aufgehängt. Damit ist die Montageseite des Wechselrichters 10 parallel zur Wand 32 und der Kühlluftkanal 17 senkrecht zur Wand 32 ausgerichtet, so dass ein Kühlluftstrom den Kühlkörper 18 in horizontaler Richtung durchströmt. Da in einer solchen Montageposition kein oder nur ein geringer Kamineffekt zu erwarten ist, kann eine Zwangslüftung vorgesehen sein, die insbesondere eine Lüftereinheit 29 gemäß Fig. 6 umfassen kann. Die Strömungsrichtung des Kühlluftstroms kann wahlweise von der Wand weg oder auf die Wand hin eingestellt werden.

**Fig. 6** zeigt eine Lüftereinheit 29 eines Wechselrichters 10, wobei die Lüftereinheit 29 mehrere Lüfter 29a aufweisen kann. Die Lüftereinheit 29 ist in dieser Ausführungsform des Wechselrichters 10 an der Montageseite des Wechselrichters 10 angeordnet. Alternativ oder zusätzlich kann eine Lüftereinheit 29a auf der der Montageseite gegenüber liegenden Seite des Wechselrichters 10 montiert sein. Die Lüftereinheit 29 ist in einer Richtung senkrecht zur Achse des Kühlluftkanals 17 verschiebbar montiert, beispielsweise indem die Lüfter 29a auf einer gemeinsamen Halteplatte angeordnet sind, die insbesondere von an den Rückseiten der Gehäuseteile 11 und 12 und/oder an der Unterseite des Gehäuseteils 13 angeordneten Führungen geführt werden kann. Eine Verschiebung der Lüftereinheit kann von einer Verriegelungsvorrichtung 30 lösbar blockiert werden. Die Verriegelungseinheit 30 gemäß Fig. 6 weist beispielhaft einen drehbar gelagerten Verriegelungshebel auf, wobei die Verriegelungsvorrichtung 30 in der in der Fig. 6 links dargestellten Stellung die Verschiebung der Lüftereinheit 29 blockiert, indem der Verriegelungshebel in eine Nut oder hinter eine Kante auf der Rückseite des Gehäuseteils 13 eingreift. Die Verriegelungsvorrichtung 30 in der in der Fig. 6 rechts dargestellten Stellung ist nicht verriegelt, so dass diese eine Verschiebung der Lüftereinheit 29 grundsätzlich ermöglichen würde. Die Lüftereinheit 29 kann somit beispielsweise zu Wartungs- oder Reparaturzwecken entnommen werden, ohne dass weitere Teile des Wechselrichters demontiert werden müssen.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Elemente können durch weitere Merkmale ergänzt werden oder die einzigen Elemente sein, auf die sich das jeweilige Verfahren oder die jeweilige Vorrichtung bezieht.

### Bezugszeichenliste

- 10: Wechselrichter
- 11: Gehäuseteil
- 11a: Grundkörper
- 11b: Deckel
- 12: Gehäuseteil
- 12a: Grundkörper
- 12b: Deckel
- 13: Gehäuseteil
- 13a: Grundkörper
- 13b: Deckel
- 14: Gehäuseteil
- 14a: Grundkörper
- 14b: Deckel
- 15: Gleichstromanschlüsse
- 16: Wechselstromanschlüsse
- 17: Kühlluftkanal
- 18: Kühlkörper
- 19a, 19b: Kühlflächen
- 20: Verbindungskanal
- 21a, 21b, 21c: Teilkanäle
- 22: Trennwand
- 23a, 23b: Teilröhren
- 24: Gleichstrom-Trennschalter
- 25: Wechselstrom-Trennschalter
- 26a, 26b: Aussparungen
- 27: Kühlrippen
- 28: Kühlkörper
- 29: Lüftereinheit
- 29a: Lüfter
- 30: Verriegelungsvorrichtung
- 31: Positioniervorrichtung
- 32: Wand
- 33: Abdeckung
- 34: Öffnungen

## Patentansprüche

1. Wechselrichter (10) zur Umwandlung eines eingangsseitigen Gleichstroms in einen ausgangsseitigen Wechselstrom zur Einspeisung in ein Wechselspannungsnetz, umfassend
- einen ersten Gehäuseteil (11) mit Gleichstromanschlüssen (15) zur Aufnahme von Gleichstromleitungen eines Gleichstromgenerators,
- einen zweiten Gehäuseteil (12) mit Wechselstromanschlüssen (16) zur Aufnahme von Wechselstromleitungen eines Wechselspannungsnetzes,
- einen dritten Gehäuseteil (13) zur Aufnahme von leistungselektronischen Komponenten eines Gleichspannungswandlers,
- einen vierten Gehäuseteil (14) zur Aufnahme von leistungselektronischen Komponenten einer Wechselrichterbrückenschaltung,
wobei die Gehäuseteile (11-14) jeweils eine im Wesentlichen ebene Rückwand aufweisen und derart angeordnet sind, dass sie einen Kühlluftkanal (17) mit im Wesentlichen rechteckigen Querschnitt umschließen, wobei der erste Gehäuseteil (11) gegenüber dem zweiten Gehäuseteil (12) und der dritte Gehäuseteil (13) gegenüber dem vierten Gehäuseteil (14) angeordnet sind,
**dadurch gekennzeichnet, dass** in dem Kühlluftkanal (17) ein Kühlkörper (18) angeordnet ist, der zwei gegenüberliegende und im Wesentlichen ebene Kühlflächen (19a, 19b) aufweist, wobei die Kühlflächen (19a, 19b) den Rückwänden des dritten Gehäuseteils (13) und des vierten Gehäuseteils (14) zugeordnet sind und mit in diesen Gehäuseteilen (13, 14) angeordneten leistungselektronischen Komponenten in thermischem Kontakt stehen.

2. Wechselrichter (10) nach Anspruch 1, **dadurch gekennzeichnet, dass** ein erster Teil eines Gleichspannungszwischenkreises in dem dritten Gehäuseteil (13) und ein zweiter Teil des Gleichspannungszwischenkreises in dem vierten Gehäuseteil (14) angeordnet sind.

3. Wechselrichter (10) nach Anspruch 2, **dadurch gekennzeichnet, dass** der erste Teil und der zweite Teil des Gleichspannungszwischenkreises über Zwischenkreisverbindungsleitungen elektrisch miteinander verbunden sind, die innerhalb eines röhrenförmigen Verbindungskanals (20) zwischen dem dritten Gehäuseteil (13) und dem vierten Gehäuseteil (14) verlaufen, wobei eine Außenwand des Verbindungskanals (20) elektrisch isolierend ausgeführt ist.

4. Wechselrichter (10) nach Anspruch 3, **dadurch gekennzeichnet, dass** der Verbindungskanal (20) mindestens zwei Teilkanäle (21a, 21b) zur Aufnahme von Zwischenkreisverbindungsleitungen mit einem positiven und einem negativen Potential aufweist, wobei die Teilkanäle (21a, 21b) axial entlang des Verbindungskanals (20) verlaufen und mittels einer axial verlaufenden Trennwand (22) elektrisch gegeneinander isoliert sind.

5. Wechselrichter (10) nach Anspruch 4, **dadurch gekennzeichnet, dass** der Verbindungskanal (20) einen dritten Teilkanal (21c) zur Aufnahme von Zwischenkreisverbindungsleitungen mit einem Mittelpunktspotentials des Gleichspannungszwischenkreises aufweist, wobei der dritte Teilkanal (21c) axial entlang des Verbindungskanals (20) verläuft und gegenüber dem ersten und dem zweiten Teilkanal (21a, 21b) mittels einer weiteren axial verlaufenden Trennwand (22) elektrisch isoliert ist.

6. Wechselrichter (10) nach einem der Ansprüche 2 bis 5, **dadurch gekennzeichnet, dass** die Zwischenkreisverbindungsleitungen ohne elektrische Isolation ausgeführt sind und insbesondere jeweils ein hochflexibles Geflecht elektrisch leitender Drähte umfassen.

7. Wechselrichter nach einem der Ansprüche 2 bis 6, **dadurch gekennzeichnet, dass** der Verbindungskanal (10) zwei Teilröhren (23a, 23b) umfasst, wobei sich jeweils eine Teilröhre (23a, 23b) in den dritten Gehäuseteil (13) und in den vierten Gehäuseteil (14) erstreckt.

8. Wechselrichter (10) nach einem der vorangehenden Ansprüchen, **dadurch gekennzeichnet, dass** in dem ersten Gehäuseteil (11) und/oder in dem zweiten Gehäuseteil (12) Wickelgüter angeordnet sind, die als Filterdrosseln und/oder als Speicherdrosseln ausgeführt und zur Filterung beziehungsweise Speicherung des umzuwandelnden Gleichstroms und/oder des umgewandelten Wechselstromes eingerichtet sind.

9. Wechselrichter (10) nach einem der vorangehenden Ansprüchen, **dadurch gekennzeichnet, dass** ein Gleichstrom-Trennschalter (24) im ersten Gehäuseteil (11) und/oder ein Wechselstrom-Trennschalter (25) im zweiten Gehäuseteil (12) angeordnet ist.

10. Wechselrichter (10) nach einem der vorangehenden Ansprüchen, **dadurch gekennzeichnet, dass** der Kühlkörper (18) ein von den Gehäuseteilen (11, 12, 13, 14) separates, einteiliges oder mehrteiliges Bauteil ist und insbesondere ein Strangpressprofil umfasst, wobei gegenüberliegende Kühlflächen (19a, 19b) des Kühlkörpers (18) in korrespondierenden Aussparungen (26a, 26b) in den Rückwänden des dritten Gehäuseteiles (13) und des vierten Gehäuseteiles (14) eingepasst sind.

11. Wechselrichter (10) nach einem der Ansprüchen 1 bis 9, **dadurch gekennzeichnet, dass** der Kühlkörper (18) durch Kühlrippen (27) gebildet wird, wobei die Kühlrippen (27) an den einander gegenüberliegenden Rückwänden des dritten Gehäuseteiles (13) und des vierten Gehäuseteiles (14) angeordnet sind.

12. Wechselrichter (10) nach einem der vorangehenden Ansprüche, **dadurch gekennzeichnet, dass** der Wechselrichter (10) mindestens einen weiteren Kühlkörper (28) aufweist, der an der Rückwand des ersten Gehäuseteils (11) oder des zweiten Gehäuseteils (12) angeordnet und zur Kühlung der in dem ersten Gehäuseteil (11) und/oder der in dem zweiten Gehäuseteil (12) angeordneten Wickelgüter eingerichtet ist, sowie mit dem Kühlluftkanal (17) in thermischer Verbindung steht, so dass der weitere Kühlkörper (28) von den Wickelgütern abgegebene Wärme an den Kühlluftkanal (17) durchströmende Kühlluft abgibt.

13. Wechselrichter (10) nach einem der vorangehenden Ansprüche, **dadurch gekennzeichnet, dass** an einem Ende des Kühlluftkanals (17) eine Lüftereinheit (29) angeordnet ist, die dazu eingerichtet ist, einen Kühlluftstrom durch den Kühlkanal (17) zu erzeugen, wobei die Lüftereinheit (29) optional in einer Richtung senkrecht zur Achse des Kühlluftkanals verschiebbar ist, wobei die Verschiebung durch eine Verriegelungsvorrichtung (30) lösbar blockiert wird, so dass die Lüftereinheit (29) aus dem Wechselrichter (10) entnommen werden kann.

14. Wechselrichter (10) nach einem der vorangehenden Ansprüche, **dadurch gekennzeichnet, dass** eine Abdeckung (33) an einer der Lüftereinheit (29) gegenüberliegenden Seite des Kühlluftkanals (17) angeordnet ist.

15. Wechselrichter (10) nach einem der vorangehenden Ansprüche, **dadurch gekennzeichnet, dass** an einer Montageseite des Wechselrichters (10) eine Positioniervorrichtung (31) vorgesehen ist, wobei die Montageseite des Wechselrichters (10) normal zur Achse des Kühlluftkanals (17) ausgerichtet ist, und .dass die Positioniervorrichtung (31) zur Aufstellung des Wechselrichters (10) auf einer im Wesentlichen horizontalen Fläche eingerichtet ist, so dass der Kühlluftkanal (17) nach einer Montage des Wechselrichters (10) lotrecht ausgerichtet ist, oder dass die Positioniervorrichtung (31) zur Aufhängung des Wechselrichters (10) an einer Wand (32) eingerichtet ist, so dass nach einer Montage die Montageseite des Wechselrichters (10) parallel zur Wand (32) und der Kühlluftkanal (17) des Wechselrichters (10) senkrecht zur Wand (32) ausgerichtet ist.

## Claims

1. Inverter (10) for converting an input-end direct current into an output-end alternating current to be fed into an AC voltage supply system, comprising
- a first housing part (11) with direct current connections (15) for receiving direct current lines of a direct current generator,
- a second housing part (12) with alternating current connections (16) for receiving alternating current lines of an AC voltage supply system,
- a third housing part (13) for accommodating power-electronics components of a DC voltage converter,
- a fourth housing part (14) for accommodating power-electronics components of an inverter bridge circuit,
wherein the housing parts (11-14) each have an essentially planar rear wall and are arranged in such a way that they enclose a cooling-air duct (17) with an essentially rectangular cross section, wherein the first housing part (11) is arranged opposite the second housing part (12) and the third housing part (13) is arranged opposite the fourth housing part (14),
**characterized in that** a heat sink (18), which has two essentially planar cooling faces (19a, 19b) opposite one another is arranged in the cooling-air duct (17), wherein the cooling faces (19a, 19b) are assigned to the rear walls of the third housing part (13) and the fourth housing part (14) and are in thermal contact with power-electronics components arranged in these housing parts (13, 14) .

2. Inverter (10) according to claim 1, **characterized in that** a first part of a DC voltage intermediate circuit is arranged in the third housing part (13) and a second part of a DC voltage intermediate circuit is arranged in the fourth housing part (14) .

3. Inverter (10) according to claim 2, **characterized in that** the first part and the second part of the DC voltage intermediate circuit are electrically connected to one another via intermediate circuit connecting lines which run within a tubular connecting duct (20) between the third housing part (13) and the fourth housing part (14), wherein an outer wall of the connecting duct (20) is embodied in an electrically insulating fashion.

4. Inverter (10) according to claim 3, **characterized in that** the connecting duct (20) has at least two partial ducts (21a, 21b) for accommodating intermediate circuit connecting lines with a positive potential and a negative potential, wherein the partial ducts (21a, 21b) run axially along the connecting duct (20) and are electrically insulated from one another by means of an axially running dividing wall (22).

5. Inverter (10) according to claim 4, **characterized in that** the connecting duct (20) has a third partial duct (21c) for accommodating intermediate circuit connecting lines with a center point potential of the DC voltage intermediate circuit, wherein the third partial duct (21c) runs axially along the connecting duct (20) and is electrically insulated from the first and the second partial ducts (21a, 21b) by means of a further axially running dividing wall (22).

6. Inverter (10) according to one of claims 2 to 5, **characterized in that** the intermediate circuit connecting lines are embodied without electrical insulation and each comprise, in particular, a highly flexible mesh of electrically conductive wires.

7. Inverter according to one of claims 2 to 6, **characterized in that** the connecting duct (10) comprises two partial tubes (23a, 23b), wherein one partial tube (23a, 23b) extends into the third housing part (13) and one partial tube (23a, 23b) into the fourth housing part (14), respectively.

8. Inverter (10) according to one of the preceding claims, **characterized in that** coiled wire products, which are embodied as filter chokes and/or as storage chokes and are configured for filtering or storing the direct current which is to be converted and/or the alternating current which has been converted, are arranged in the first housing part (11) and/or in the second housing part (12).

9. Inverter (10) according to one of the preceding claims, **characterized in that** a direct current circuit breaker (24) is arranged in the first housing part (11) and/or an alternating current circuit breaker (25) is arranged in the second housing part (12).

10. Inverter (10) according to one of the preceding claims, **characterized in that** the heat sink (18) comprises a single-part or multi-part component which is separate from the housing parts (11, 12, 13, 14), and comprises, in particular, an extruded profile, wherein cooling faces (19a, 19b) of the heat sink (18) which are opposite one another are fitted into corresponding cutouts (26a, 26b) in the rear walls of the third housing part (13) and of the fourth housing part (14).

11. Inverter (10) according to one of claims 1 to 9, **characterized in that** the heat sink (18) is formed by cooling ribs (27), wherein the cooling ribs (27) are arranged on the rear walls of the third housing part (13) and of the fourth housing part (14) which are opposite one another.

12. Inverter (10) according to one of the preceding claims, **characterized in that** the inverter (10) has at least one further heat sink (28) which is arranged on the rear wall of the first housing part (11) or of the second housing part (12) and is configured to cool the coiled wire products which are arranged in the first housing part (11) and/or the coiled wire products which are arranged in the second housing part (12), and is thermally connected to the cooling-air duct (17), such that the further heat sink (28) outputs heat, which has been output by the coiled wire products, to cooling air which flows through the cooling-air duct (17).

13. Inverter (10) according to one of the preceding claims, **characterized in that** a fan unit (29), which is configured to generate a stream of cooling air through the cooling duct (17), is arranged at one end of the cooling-air duct (17), wherein the fan unit (29) optionally is capable of being slid in a direction perpendicular to the axis of the cooling-air duct, wherein the sliding is blocked in a releasable fashion by a locking device (30), such that the fan unit (29) can be removed from the inverter (10).

14. Inverter (10) according to one of the preceding claims, **characterized in that** a cover (33) is arranged on a side of the cooling-air duct (17) which is opposite the fan unit (29).

15. Inverter (10) according to one of the preceding claims, **characterized in that** a positioning device (31) is provided on a mounting side of the inverter (10), wherein the mounting side of the inverter (10) is oriented in a normal fashion with respect to the axis of the cooling-air duct (17), and **in that** the positioning device (31) is configured for positioning the inverter (10) in an upright fashion on an essentially horizontal face such that after the inverter (10) has been mounted, the cooling-air duct (17) is oriented vertically, or that the positioning device (31) is configured to suspend the inverter (10) from a wall (32), such that after mounting, the mounting side of the inverter (10) is oriented parallel with respect to the wall (32) and the cooling-air duct (17) of the inverter (10) is oriented perpendicularly with respect to the wall (32).

## Revendications

1. Onduleur (10) destiné à la transformation d'un courant continu d'entrée en un courant alternatif de sortie afin de l'injecter dans un réseau à tension alternative, comprenant
- une première partie de boîtier (11) avec des branchements de courant continu (15) destinés à la réception de lignes de courant continu d'un générateur de courant continu,
- une deuxième partie de boîtier (12) avec des branchements de courant alternatif (16) destinés à la réception de lignes de courant alternatif d'un réseau à tension alternative,
- une troisième partie de boîtier (13) destinée à la réception de composants électroniques de puissance d'un convertisseur de tension continue,
- une quatrième partie de boîtier (14) destinée à la réception de composants électroniques de puissance d'un circuit en pont de l'onduleur,
les parties de boîtier (11-14) présentant respectivement une paroi arrière essentiellement plane et étant disposées de telle sorte qu'elles englobent un canal d'air de refroidissement (17) avec une section transversale essentiellement rectangulaire, la première partie de boîtier (11) étant disposée en face de la deuxième partie de boîtier (12), et la troisième partie de boîtier (13) étant disposée en face de la quatrième partie de boîtier (14),
**caractérisé en ce que**, dans le canal d'air de refroidissement (17), il est disposé un corps de refroidissement (18) qui présente deux surfaces de refroidissement (19a, 19b) se faisant face et essentiellement planes, les surfaces de refroidissement (19a, 19b) étant affectées aux parois arrière de la troisième partie de boîtier (13) et de la quatrième partie de boîtier (14), et étant en contact thermique avec des composants électroniques de puissance disposés dans ces parties de boîtier (13, 14).

2. Onduleur (10) selon la revendication 1, **caractérisé en ce qu'**une première partie d'un circuit intermédiaire à tension continue est disposée dans la troisième partie de boîtier (13), et une deuxième partie du circuit intermédiaire à tension continue est disposée dans la quatrième partie de boîtier (14).

3. Onduleur (10) selon la revendication 2, **caractérisé en ce que** la première partie et la deuxième partie du circuit intermédiaire à tension continue sont raccordées électriquement l'une à l'autre par le biais de lignes de raccordement de circuit intermédiaire qui sont placées à l'intérieur d'un canal de raccordement (20) tubulaire entre la troisième partie de boîtier (13) et la quatrième partie de boîtier (14), une paroi extérieure du canal de raccordement (20) étant réalisée de façon électriquement isolante.

4. Onduleur (10) selon la revendication 3, **caractérisé en ce que** le canal de raccordement (20) présente au moins deux canaux partiels (21a, 21b) destinés à la réception de lignes de raccordement de circuit intermédiaire avec un potentiel positif et un potentiel négatif, les canaux partiels (21a, 21b) étant placés axialement le long du canal de raccordement (20) et étant électriquement isolés l'un de l'autre au moyen d'une cloison (22) placée axialement.

5. Onduleur (10) selon la revendication 4, **caractérisé en ce que** le canal de raccordement (20) présente un troisième canal partiel (21c) destiné à la réception de lignes de raccordement de circuit intermédiaire avec un potentiel de point central du circuit intermédiaire à tension continue, le troisième canal partiel (21c) étant placé axialement le long du canal de raccordement (20) et étant électriquement isolé vis-à-vis du premier et du deuxième canal partiel (21a, 21b) au moyen d'une autre cloison (22) placée axialement.

6. Onduleur (10) selon l'une des revendications 2 à 5, **caractérisé en ce que** les lignes de raccordement de circuit intermédiaire sont réalisées sans isolation électrique et comprennent en particulier respectivement un entrelacement très flexible de fils électriquement conducteurs.

7. Onduleur selon l'une des revendications 2 à 6, **caractérisé en ce que** le canal de raccordement (10) comprend deux tubes partiels (23a, 23b), respectivement un tube partiel (23a, 23b) s'étendant dans la troisième partie de boîtier (13) et dans la quatrième partie de boîtier (14).

8. Onduleur (10) selon l'une des revendications précédentes, **caractérisé en ce que**, dans la première partie de boîtier (11) et/ou dans la deuxième partie de boîtier (12), il est disposé des produits bobinés qui sont réalisés en tant que bobines de filtrage et/ou en tant que bobines d'accumulation et qui sont agencés pour le filtrage ou respectivement pour l'accumulation du courant continu à transformer et/ou du courant alternatif transformé.

9. Onduleur (10) selon l'une des revendications précédentes, **caractérisé en ce qu'**un disjoncteur à courant continu (24) est disposé dans la première partie de boîtier (11) et/ou un disjoncteur à courant alternatif (25) est disposé dans la deuxième partie de boîtier (12).

10. Onduleur (10) selon l'une des revendications précédentes, **caractérisé en ce que** le corps de refroidissement (18) est un composant séparé des parties de boîtier (11, 12, 13, 14), en une ou plusieurs parties, et comprend en particulier un profilé extrudé, des surfaces de refroidissement (19a, 19b) opposées du corps de refroidissement (18) étant insérées dans des évidements (26a, 26b) correspondants dans les parois arrière de la troisième partie de boîtier (13) et de la quatrième partie de boîtier (14).

11. Onduleur (10) selon l'une des revendications 1 à 9, **caractérisé en ce que** le corps de refroidissement (18) est formé par des ailettes de refroidissement (27), les ailettes de refroidissement (27) étant disposées sur les parois arrière mutuellement opposées de la troisième partie de boîtier (13) et de la quatrième partie de boîtier (14).

12. Onduleur (10) selon l'une des revendications précédentes, **caractérisé en ce que** l'onduleur (10) présente au moins un autre corps de refroidissement (28) qui est disposé sur la paroi arrière de la première partie de boîtier (11) ou de la deuxième partie de boîtier (12) et qui est agencé pour le refroidissement des produits bobinés disposés dans la première partie de boîtier (11) et/ou dans la deuxième partie de boîtier (12), de même qu'il est en contact thermique avec le canal d'air de refroidissement (17) de telle sorte que l'autre corps de refroidissement (28) délivre, à l'air de refroidissement parcourant le canal d'air de refroidissement (17), de la chaleur délivrée par les produits bobinés.

13. Onduleur (10) selon l'une des revendications précédentes, **caractérisé en ce que**, à une extrémité du canal d'air de refroidissement (17), il est disposé une unité de ventilateur (29) qui est agencée pour produire un flux d'air de refroidissement à travers le canal d'air de refroidissement (17), l'unité de ventilateur (29) pouvant optionnellement coulisser dans une direction perpendiculairement à l'axe du canal d'air de refroidissement, le coulissement étant bloqué de façon amovible par un dispositif de verrouillage (30) de telle sorte que l'unité de ventilateur (29) peut être enlevée de l'onduleur (10).

14. Onduleur (10) selon l'une des revendications précédentes, **caractérisé en ce qu'**un recouvrement (33) est disposé sur un côté du canal d'air de refroidissement (17) qui est en face de l'unité de ventilateur (29).

15. Onduleur (10) selon l'une des revendications précédentes, **caractérisé en ce qu'**un dispositif de positionnement (31) est prévu sur un côté de montage de l'onduleur (10), le côté de montage de l'onduleur (10) étant orienté à angle droit par rapport à l'axe du canal d'air de refroidissement (17), et **en ce que** le dispositif de positionnement (31) est agencé pour mettre en place l'onduleur (10) sur une surface essentiellement horizontale de telle sorte que, après un montage de l'onduleur (10), le canal d'air de refroidissement (17) est orienté verticalement, ou **en ce que** le dispositif de positionnement (31), pour l'accrochage de l'onduleur (10), est agencé sur une paroi (32) de telle sorte que, après un montage, le côté de montage de l'onduleur (10) est orienté parallèlement à la paroi (32), et le canal d'air de refroidissement (17) de l'onduleur (10) est orienté perpendiculairement à la paroi (32).
